# EUROPÄISCHE PATENTANMELDUNG

(11) **EP 1 622 237 A1**
(43) Veröffentlichungstag der Anmeldung: **01.02.2006**
(21) Anmeldenummer: 04090300.7
(22) Anmeldetag: 28.07.2004
(51) Int. Cl.: H01S 5/022, G02B 6/42, H01L 33/00

(54) **Optisches oder elektronisches Modul und Verfahren zu dessen Herstellung**

(71) Anmelder: Infineon Technologies Fiber Optics GmbH, 13629 Berlin (DE)
(72) Erfinder: Hurt, Hans, 93049 Regensburg (DE); Wittl, Josef, 92331 Parsberg (DE); Weberpals, Frank, 93047 Regensburg (DE); Schunk, Nikolaus, 93142 Maxhütte-Haidhof (DE); Auburger, Albert, 93128 Regenstauf (DE); Paulus, Stefan, 93197 Zeitlarn (DE); Lichtenegger, Thomas, 93087 Alteglofsheim (DE)
(74) Vertreter: Müller, Wolfram Hubertus

(57) **Zusammenfassung**

Bezeichnung der Erfindung: Optisches oder elektronisches Modul und Verfahren zu dessen Herstellung.

Die Erfindung begrifft ein optisches oder elektronisches Modul mit mindestens einer optischen oder elektronischen Komponente (1), die einen Wirkbereich (11) aufweist, über den sie in Wirkverbindung mit der Umgebung steht, und einem Kunststoffgehäuse (4), in dem die Komponente (1) angeordnet ist. Das Kunststoffgehäuse (1) weist einen ersten Bereich (41, 61) auf, der aus einer transparenten Kunststoffmasse besteht, und einen zweiten Bereich (42), der aus einer nichttransparenten Kunststoffmasse besteht. Der erste Bereich (41, 61) erstreckt sich dabei angrenzend an den Wirkbereich (11) der Komponente (1). Des weiteren betrifft die Erfindung Verfahren zur Herstellung eines solches Moduls.

## Beschreibung

Bezeichnung der Erfindung: Optisches oder elektronisches Modul und Verfahren zu dessen Herstellung.

Die Erfindung betrifft ein optisches oder elektronisches Modul und mehrere Verfahren zu dessen Herstellung.

Es ist bekannt, optoelektronische Module mit einem transparenten Vergussmaterial zu vergießen. So ist beispielsweise aus der DE 199 09 242 A1 ein opto-elektronisches Modul bekannt, bei dem ein Leadframe mit einem opto-elektronischen Wandler in einem Modulgehäuse positioniert und mit einem lichtdurchlässigen, formbaren Kunststoffmaterial vergossen wird. Eine Lichtein- oder Auskopplung erfolgt über eine Lichtleitfaser, die an einem Stutzen des Modulgehäuses angekoppelt wird. Auf dem Leadframe befindet sich auch der Treiberbaustein bzw. Empfangsbaustein für den opto-elektronischen Wandler.

Allerdings weist die Verwendung von Vergussmaterialien, die für den jeweiligen Wellenlängenbereich transparent sind, insofern Nachteile auf, als transparente Vergussmaterialien in der Regel einen hohen thermischen Ausdehnungskoeffizienten besitzen und dementsprechend bei großen Temperaturschwankungen Spannungen im Package auftreten, die insbesondere die empfindlichen Bonddraht-Verbindungen beschädigen können.

Es ist daher grundsätzlich vorteilhaft, für ein Vergießen oder Verpressen der Komponenten eines Moduls nichttransparente Kunststoffmaterialien einzusetzen, die mit Füllstoffen versehen sind, die einen günstigen thermischen Ausdehnungskoeffizienten des Kunststoffmaterials bereitstellen. Nachteilig bei der Verwendung solcher Kunststoffe als Vergussmaterial ist, dass innerhalb des Vergussmaterials kein optischer Pfad realisiert werden kann.

Der vorliegenden Erfindung liegt die Aufgabe zu Grunde, ein optisches oder elektronisches Modul sowie Verfahren zu dessen Herstellung bereitzustellen, die trotz eines Vergießens mit einem nichttransparenten Vergußmaterial gute thermische Eigenschaften des Moduls bereitstellen.

Diese Aufgabe wird erfindungsgemäß durch ein optisches oder elektronisches Modul mit den Merkmalen des Anspruchs 1 sowie Verfahren zur Herstellung eines mit einem Kunststoffgehäuse versehenen optischen oder elektronischen Moduls mit den Merkmalen der Ansprüche 12, 15, 16 und 18 gelöst. Bevorzugte und vorteilhafte Ausgestaltungen der Erfindung sind in den Unteransprüchen angegeben.

Danach zeichnet sich die erfindungsgemäße Lösung dadurch aus, dass das Kunststoffgehäuse einen ersten Bereich aufweist, der aus einer transparenten Kunststoffmasse besteht, und einen zweiten Bereich, der aus einer nichttransparenten Kunststoffmasse besteht. Der erste Bereich mit der nichttransparenten Kunststoffmasse grenzt dabei an den Wirkbereich der Komponente an und erstreckt sich bevorzugt ausschließlich angrenzend an die Komponente. Andere Bauteile des Moduls, wie beispielsweise ein elektrischer IC-Chip, Widerstände, Kondensatoren etc., sowie ein eventuell vorhandener Träger bleiben dagegen von der transparenten Kunststoffmasse im wesentlichen frei. Sie sind mit der nicht transparenten Kunststoffmasse, die ein günstiges Temperaturverhalten aufweist, ummantelt.

Die erfindungsgemäße Lösung basiert also auf dem Gedanken, für die Ummantelung zwei Kunststoffe zu verwenden: einen transparenten Kunststoff und einen nichttransparenten Kunststoff. Das Volumen des transparenten Kunststoffs wird dabei erfindungsgemäß minimiert und sein Einsatz lokal begrenzt. Dies ermöglicht den Einsatz des erfindungsgemäßen optischen oder elektronischen Moduls auch bei hohen Umgebungstemperaturen.

Unter einem Wirkbereich der optischen oder elektrischen Komponente wird jeder Bereich bezeichnet, der eine Wirkverbindung der Komponente mit der Umgebung ermöglicht. Beispielsweise handelt es sich um den photosensitiven Bereich einer Photodiode, um den Sensorbereich eines Drucksensors oder eines Temperatursensors, um den lichtemittierenden Bereich eines Halbleiterlasers oder einer LED oder um die der Modul-Außenseite zugewandte Fläche einer Linse, eines Spiegels oder eines Prismas.

In einer bevorzugten Ausgestaltung des Moduls ist vorgesehen, dass angrenzend an den ersten Bereich eine Öffnung im zweiten Bereich ausgebildet ist, wobei der Wirkbereich der Komponente über den ersten Bereich und die Öffnung mit der Umgebung in Wirkverbindung steht. Zur Herstellung einer solchen Ausgestaltung ist vorgesehen, dass die Komponente nach Ummanteln mit der transparenten Kunststoffmasse vollständig mit der nichttransparenten Kunststoffmasse ummantelt wird. Anschließend wird der Bereich über dem Wirkbereich der Komponente partiell etwa durch Fräsen oder Laserabtragen wieder entfernt, bis die optisch transparente Kunststoffmasse des ersten Bereichs freigelegt ist. Dabei entsteht eine Öffnung im zweiten Bereich.

In einer bevorzugten Weiterbildung ist dabei vorgesehen, dass an der dem Wirkbereich der Komponente abgewandten Seite des ersten Bereichs eine lichtformende oder lichtführende Struktur ausbildet ist. Beispielsweise ist eine Linse, eine Fresnellinse oder ein Lichtleiter in dem ersten Bereich ausgebildet.

In einer weiteren Ausgestaltung schließt sich der zweite Bereich seitlich an den ersten Bereich an und umhüllt dabei weitere Bauteile des Moduls mit der nichttransparenten Kunststoffmasse. Ein solches weiteres Bauteil kann dabei auch lediglich ein Träger des Moduls sein, auf dem die Komponente angeordnet ist.

In einer Variante dieser Ausgestaltung bildet die Komponente und der daran angrenzende erste Bereich des Kunststoffgehäuses ein vorgefertigtes Package aus (ein "premolded package"). Es kann sich beispielsweise um eine komplette LED mit SMD-Kontakten oder um eine Laserdiode mit SMD-Kontakten handeln. Dieses premolded Package ist auf einen Träger des Moduls aufgesetzt. Der nachfolgend angebrachte zweite Bereich des Kunststoffgehäuses umschließt das vorgefertigte Package zwar teilweise, deckt aber den ersten Bereich des Kunststoffgehäuses nicht ab, so dass der optische Pfad erhalten bleibt. Hierzu sind die Geometrien des für die Ummantelung verwendeten Spritzwerkzeugs entsprechend ausgelegt.

Bei dieser Variante ist die transparente Kunststoffmasse also vorab auf die optische oder elektronische Komponente aufgebracht worden. Im Spritzgusswerkzeug erfolgt nur noch eine Applikation des nichttransparenten Kunststoffs.

In einer weiteren Variante werden die beiden nebeneinander angeordneten Bereiche (mit transparenter Kunststoffmasse und mit nichttransparenter Kunststoffmasse) hintereinander hergestellt, etwa in einem 2-Komponenten Spritzgussverfahren. Bevorzugt ist dabei vorgesehen, dass sich an der Grenze zwischen dem ersten Bereich des Kunststoffgehäuses und dem zweiten Bereich des Kunststoffgehäuses ein Bondumsteiger befindet, von dem sich ein erster Bonddraht in den ersten Bereich und ein zweiter Bonddraht in den zweiten Bereich erstreckt. Dies ermöglicht die elekrische Kontaktierung der Komponente trotz der Verwendung zweier Kunststoffe. Die Grenze zwischen den Kunststoffen verläuft gerade durch den Bondumsteiger.

Allgemein wird angemerkt, dass die optische oder elektronische Komponente auf einem Träger angeordnet sein kann. Der Träger des Moduls ist bevorzugt als Leadframe, auch als Metallträger oder Stanzgitter bezeichnet, ausgebildet. Das Leadframe weist dabei bevorzugt mindestens einen planen Trägerbereich, auch als "die pad" oder "Chipinsel" bezeichnet, sowie eine Mehrzahl von Kontaktbeinen auf, die sich am Randbereich des Leadframes befinden. Die optische oder elektronische Komponente wird dabei jeweils auf einem Trägerbereich angeordnet. Grundsätzlich können statt eines Leadframes aber auch beliebige andere Träger eingesetzt werden, beispielsweise Träger, die aus einer strukturierten Kunststofffolie bestehen oder aus einer Leiterplatte. Auch kann auf einen gesonderten Träger grundsätzlich ganz verzichtet werden.

In einer weiteren bevorzugten Ausgestaltung ist ein Träger vorgesehen und sind die optische oder elektronische Komponente auf der einen, ersten Seite des Trägers und mindestens ein weiteres Bauteil des Moduls auf der anderen, zweiten Seite des Trägers angeordnet. Dabei umhüllt der zweite Bereich des Kunststoffgehäuses die auf der zweiten Seite des Trägers angeordneten Bauteile. Auf der ersten Seite befindet sich ausschließlich die transparente Kunststoffmasse. Diese Aufteilung erlaubt eine einfache Applikation der Kunststoffmassen und Herstellung des Moduls. Alternativ erstreckt sich aber auch zweite Bereich des Kunststoffgehäuses teilweise auf die erste Seite des Trägers, deckt dabei aber den ersten Bereich mit der transparenten Kunststoffmasse nicht ab. Hierdurch werden die thermischen Eingenschaften weiter verbessert.

Die optische oder elektronische Komponente ist bei dieser Ausgestaltung bevorzugt mittels einer Leiterplatte mit Durchkontaktierungen auf dem Träger angeordnet. Die Leiterplatte besteht beispielsweise aus üblichem Leiterplattenmaterial oder einer strukturierten Kunststofffolie (Z.B. aus Kapton®).

Die optische Komponente ist bevorzugt ein opto-elektronisches Sendebauelement oder ein opto-elektronisches Empfangsbauelement, insbesondere eine Photodiode, eine LED oder ein Halbleiterlaser. Jedoch kann es sich bei dem optischen Bauelement beispielsweise auch um eine Linse, einen optischen Filter, ein Prisma, einen Spiegel oder dergleichen handeln. Sofern es sich bei der Komponente um eine elektronische Komponente handelt, ist diese bevorzugt ein Sensor, insbesondere ein Drucksensor oder ein Temperatursensor.

Ein erstes Verfahren zum Herstellen eines mit einem Kunststoffgehäuse versehenen optischen oder elektronischen Moduls sieht folgende Schritte vor:
- Bereitstellen mindestens einer optischen oder elektronischen Komponente, wobei die Komponente einen Wirkbereich aufweist, über den sie im fertigen Modul in Wirkverbindung mit der Umgebung steht,
- Umhüllen der Komponente zumindest angrenzend an den Wirkbereich mit einer ersten, transparenten Kunststoffmasse,
- Umhüllen der Komponente, der ersten Kunststoffmasse und, soweit vorhanden, weiterer Bauteile des Moduls mit einer zweiten, nichttransparenten Kunststoffmasse,
- partielles Entfernen der zweiten Kunststoffmasse von außen derart, dass die erste Kunststoffmasse freigelegt wird und die Komponente über die erste Kunststoffmasse in Wirkverbindung mit der Umgebung treten kann.

Es ist also vorgesehen, dass die Komponente nach Ummanteln mit der transparenten Kunststoffmasse vollständig mit der nichttransparenten Kunststoffmasse ummantelt wird. Anschließend wird ein Bereich über der Komponente partiell beispielsweise durch Fräsen oder Laserabtragen wieder entfernt, bis die optisch transparente Kunststoffmasse freigelegt ist.

Ein zweites Verfahren zum Herstellen eines mit einem Kunststoffgehäuse versehenen optischen oder elektronischen Moduls sieht folgende Schritte vor:
- Bereitstellen mindestens eines vorgefertigen Package mit einer optischen oder elektronischen Komponente und einer Umhüllung der Komponente bestehend aus einer ersten, transparenten Kunststoffmasse, wobei die Komponente einen Wirkbereich aufweist, über den sie im fertigen Modul in Wirkverbindung mit der Umgebung steht, und die Umhüllung zumindest an den Wirkbereich angrenzt,
- Anordnen des vorgefertigen Package auf einem Träger,
- Umhüllen des Package, des Trägers und, soweit vorhanden, weiterer Bauteile des Moduls mit einer zweiten, nichttransparenten Kunststoffmasse, wobei
- die zweite Kunststoffmasse derart angebracht wird, dass sie das vorgefertigte Package teilweise umschließt, die erste Kunststoffmasse des vorgefertigten Package aber nicht abdeckt.

Bei diesem Verfahren wird die nichttransparente Kunststoffmasse in einem vorgefertigten Package realisiert. Anschließend erfolgt das Vergießen oder Verpressen mit der nichttransparenten Vergussmasse.

Ein drittes, gegenüber dem zweiten Verfahren abgewandeltes Verfahren zum Herstellen eines mit einem Kunststoffgehäuse versehenen optischen oder elektronischen Moduls sieht folgende Schritte vor:
- Bereitstellen mindestens eines vorgefertigen Package mit einer optischen oder elektronischen Komponente und einer Umhüllung der Komponente bestehend aus einer ersten, transparenten Kunststoffmasse, wobei die Komponente einen Wirkbereich aufweist, über den sie im fertigen Modul in Wirkverbindung mit der Umgebung steht, und die Umhüllung zumindest an den Wirkbereich angrenzt,
- Anordnen des vorgefertigen Package auf einem Träger,
- vollständiges Umhüllen des Package, des Trägers und, soweit vorhanden, weiterer Bauteile des Moduls mit einer zweiten, nichttransparenten Kunststoffmasse, und
- partielles Entfernen der zweiten Kunststoffmasse von außen derart, dass die erste Kunststoffmasse des Package freigelegt wird und die Komponente über die erste Kunststoffmasse in Wirkverbindung mit der Umgebung treten kann.

Es ist dabei bevorzugt vorgesehen, dass das partielle Entfernen der zweiten Kunststoffmasse durch einen Fräsprozess oder ein Laser-Abtragverfahren erfolgt. Dabei wird die zweite nichttransparente Kunststoffmasse bis auf die erste transparente Kunststoffmasse abgetragen.

Ein viertes Verfahren zum Herstellen eines mit einem Kunststoffgehäuse versehenen optischen oder elektronischen Moduls sieht folgende Schritte vor:
- Bereitstellen mindestens einer optischen oder elektronischen Komponente, wobei die Komponente einen Wirkbereich aufweist, über den sie im fertigen Modul in Wirkverbindung mit der Umgebung steht,
- Umhüllen der Komponente zumindest angrenzend an den Wirkbereich mit einer ersten, transparenten Kunststoffmasse,
- Umhüllen mindestens eines weiteren Bauteils des Moduls mit einer zweiten, nichttransparenten Kunststoffmasse,
- wobei die erste und die zweite Kunststoffmasse in unterschiedlichen Bereichen des Moduls ausgebildet werden.

Dabei ist in einer Variante vorgesehen, dass die erste und die zweite Kunststoffmasse nebeneinander im Modul ausgebildet werden.

In einer zweiten Variante ist zusätzlich ein Träger vorgesehen, auf dessen einen, ersten Seite sich die optische oder elektronische Komponente befindet, und auf deren anderer, zweiten Seite sich das mindestens eine weitere Bauteil des Moduls befindet, wobei die erste und die zweite Kunststoffmasse auf unterschiedlichen Seiten des Moduls angebracht werden. Das weitere Bauteil kann auch lediglich der Träger sein.

Ein Umhüllen der Komponente mit Kunststoffmasse umfasst bevorzugt ein Vergießen oder Verpressen der Komponente mit der Kunststoffmasse. Das Vergießen oder Verpressen kann dabei in einem speziellen Werkzeug, insbesondere einem Spritzgusswerkzeug erfolgen.

Die Erfindung wird nachfolgend unter Bezugnahme auf die Figuren anhand mehrerer Ausführungsbeispiele näher erläutert.
Es zeigen:
- Fig. 1a: einen Querschnitt durch Komponenten eines ersten Ausführungsbeispieles eines optischen Moduls nach einem ersten Herstellungsschritt;
- Fig. 1b: einen Querschnitt durch Komponenten des optischen Moduls der Fig. 1a nach einem weiteren Herstellungsschritt;
- Fig. 1c: im Querschnitt das fertige optische Modul gemäß dem ersten Ausführungsbeispiel;
- Fig. 2a: im Querschnitt ein zweites Ausführungsbeispiel eines optischen Moduls;
- Fig. 2b: eine Detailansicht eines vorgefertigten Package des optischen Moduls der Fig. 2a;
- Fig. 3: einen Querschnitt durch ein drittes Ausführungsbeispiel eines optischen Moduls;
- Fig. 4: einen Querschnitt durch ein viertes Ausführungsbeispiel eines optischen Moduls.

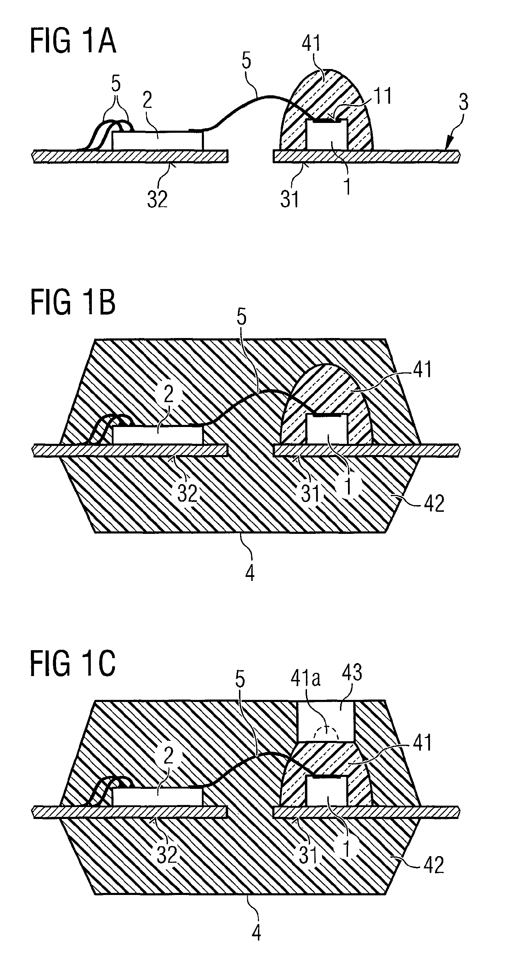

Die Figur 1c zeigt ein erstes Ausführungsbeispiel eines optischen Moduls mit einer optischen Komponente 1 und einem zugeordneten elektronischen Baustein 2, die auf einem Leadframe 3 angeordnet sind, sowie mit einem Kunststoffgehäuse 4, das zum einen aus einem transparenten Kunststoffmaterial 41 und zum anderen aus einem nichttransparenten Kunststoffmaterial 42 besteht und dementsprechende Bereiche 41, 42 ausbildet. In dem Gehäuse 4 befindet sich angrenzend an das nichttransparente Material 42 eine Gehäuseöffnung 43.

Bei der optischen Komponente 1 handelt es sich beispielsweise um eine Lumineszenzdiode (LED), einen Halbleiterlaser oder eine Photodiode. Bei dem elektronischen Baustein 2 handelt es sich beispielsweise um einen Treiber oder einen Vorverstärker. Die optische Komponente 2 ist bevorzugt als vorgefertigter Chip ausgebildet. Der elektronische Baustein 2 ist bevorzugt als integrierter Schaltkreis (IC) ausgebildet.

Die optische Komponente 1 weist an ihrer Oberseite eine Wirkfläche 11 auf. Beispielsweise handelt es sich um eine lichtemittierende Fläche 11 eines LED-Chips.

Der Leadframe 3 weist zwei plane Trägerflächen 31, 32 auf, die auch als "die pad" bezeichnet werden und auf denen zum einen die optische Komponente 1 und zum anderen der elektronische Baustein 2 angeordnet sind. Des weiteren besitzt der Leadframe 3 an seinem Rand eine Mehrzahl von Kontaktbeinen (leads). Die Kontaktbeine stehen dabei aus dem Gehäuse 4 hervor. Derartige Leadframes 3 sind im Stand der Technik bekannt, so dass hierauf nicht weiter eingegangen wird.

Die Figur 1a zeigt einen ersten Verfahrensschritt bei der Herstellung des in Figur 1c dargestellten Moduls. Auf dem Leadframe 3 sind auf den Trägerbereichen 31, 32 die optische Komponente 1 und der elektronische Baustein 2 angeordnet. Eine elektrische Kontaktierung dieser Modulkomponenten 1, 2 erfolgt zum einen durch einen Kontakt auf der Unterseite, der direkt mit der jeweiligen Trägerfläche 31, 32 elektrisch verbunden ist, sowie zum anderen über Bonddrähte 5.

Auf die optische Komponente 1 wird ein Tropfen transparenten Kunststoffmaterials 41 aufgebracht und erhärtet. Ein solcher transparenter Tropfen wird auch als "Globe Top" bezeichnet.

Anschließend wird gemäß der Figur 1b die gesamte Anordnung mit einem nichttransparenten Kunststoffmaterial 42, das Füllstoffe zur Verbesserung der physikalischen Eigenschaften enthält, vergossen oder verpresst. Beispielsweise wird das nichttransparente Kunststoffmaterial 42 in einem Spritzgussverfahren um die bereits vorhandenen Komponenten, insbesondere auch um den Tropfen des transparenten Kunststoffmaterials 41 verpresst.

Es ist nun noch erforderlich, zur Bereitstellung eines optischen Fensters und der Möglichkeit, dass die optische Komponente 1 mit der Außenwelt kommuniziert, einen Teilbereich des nichttransparenten Kunststoffmaterials 42 abzutragen, und zwar den Teilbereich, der sich zwischen dem transparenten Kunststoffmaterial 41 und der Außenseite des Gehäuses 4 befindet. Das Freilegen erfolgt beispielsweise durch eine Fräsvorrichtung oder über eine Laser-Abtragvorrichtung. Es wird dabei die in Figur 1c dargestellte Gehäuseöffnung 43 ausgebildet.

Ein Abtragen der nichttransparenten Kunststoffmasse 42 im Bereich des späteren Gehäusefensters 43 erfolgt dabei soweit, bis das optisch transparente Material 41 und damit das optische Fenster der Komponente 1 freigelegt ist.

Es wird bei dieser Gelegenheit darauf hingewiesen, dass der Begriff "optisch transparent" oder "transparent" im Sinne der vorliegenden Erfindung derart zu verstehen ist, dass das jeweilige Material für die von der betrachteten Komponente ausgesandte bzw. empfangene Wellenlänge transparent ist.

In einer Abwandlung des optischen Moduls der Figur 1 ist vorgesehen, im transparenten Material nach Freilegen des optischen Fensters 43 eine bestimmte Geometrie 41a zu realisieren. Dies ist in der Figur 1c gestrichelt dargestellt. Insbesondere kann eine lichtformende oder lichtführende Geometrie 41a, z. B. eine Linse, eine Fresnellinse, oder ein Lichtleiter bereitgestellt werden. Die gewünschte Geometrie wird beispielsweise mittels eines speziell geformten Fräsers oder mit Hilfe eines Lasers erzeugt.

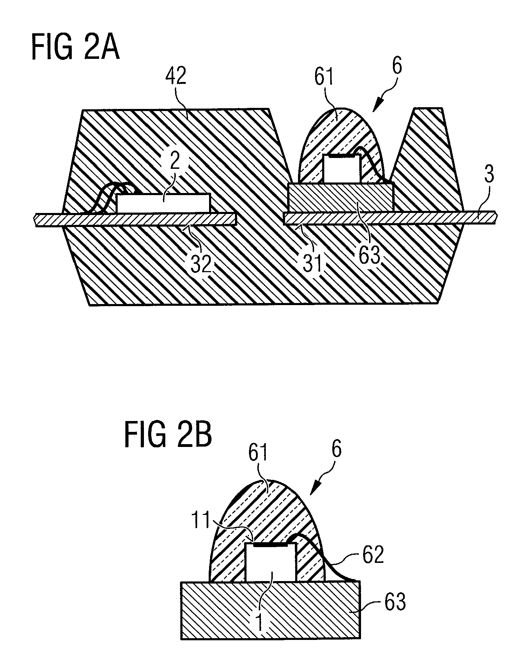

Die Figur 2a zeigt ein weiteres Ausführungsbeispiel, bei dem die optische Komponente 1 Teil eines vorgefertigten Package 6 mit SMD-Kontakten ist, das auf einen Leadframe 3 durch einen Standard-Bestückungsprozess aufgesetzt wird. Der Standard-Bestückungsprozess umfasst beispielsweise ein Kleben oder ein Löten der vorgefertigten Komponente auf das Leadframe 3.

Das vorgefertigte Package 6 ist in der Figur 2b im Detail dargestellt. Es weist neben der eigentlichen optischen Komponente 1 ein Trägermaterial 63, beispielsweise einen Submount oder einen Leadframe, sowie einen Bonddraht 62 auf. Die optische Komponente ist von einem optisch transparenten Material 61 umgeben. Der Aufbau des Package ist nur beispielhaft zu verstehen.

Nach Bestücken des Leadframes 3 mit dem vorgefertigten SMD-Package 6 wird das Leadframe 3 zusammen mit dem elektronischen Baustein 1 und dem Package 6 mit einer nichttransparenten Kunststoffmasse 42 umspritzt. Dabei sind die Geometrien des dabei verwendeten Spritzwerkzeugs so ausgelegt, dass zwar das Trägermaterial 63 des Package 6 teilweise von der nichttransparenten Vergussmasse 42 umschlossen wird, das durch das nichttransparente Material 61 bereitgestellte optische Fenster des Package 6 jedoch frei bleibt von der nichttransparenten Kunststoffmasse.

Bei dieser Ausgestaltung bildet die nichttransparente Vergussmasse 42 somit einen Bereich des Gehäuses, der sich benachbart und seitlich der transparenten Kunststoffmasse 61 des vorgefertigten Package 6 befindet.

In einer Abwandlung des Herstellungsverfahrens wird das Package 6 zunächst vollständig mit der nichttransparenten Kunststoffmasse 42 umschlossen und anschließend die nichttransparente Kunststoffmasse 42 anhand eines Fräsprozesses oder eines Laser-Abtragverfahrens bis auf das transparente Material 61 abgetragen, entsprechend dem Ausführungsbeispiel der Fig. 1a bis 1c.

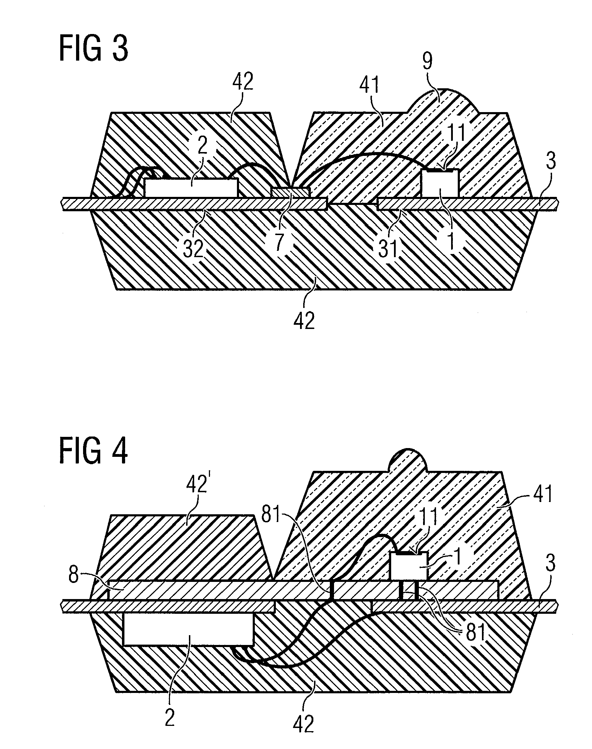

Die Figur 3 zeigt eine dritte Ausführungsform eines Moduls mit einer optischen Komponente 1, einem zugeordneten elektrischen Baustein 2, einem Träger 3 mit zwei Trägerbereichen 31, 32, einer transparenten Vergussmasse 41 und einer nicht transparenten Vergussmasse 42. Die transparente Vergussmasse 41 bildet dabei zusätzlich eine integrierte Linse 9 aus.

Das Modul der Figur 3 wird mit einem 2-Komponenten-Spritzverfahren hergestellt. Das optische Bauelement 1, das sich auf dem einen Leadframe-Trägerbereich 31 befindet, wird mit der transparenten Kunststoffmasse 41 vergossen. Sofern der entsprechende Leadframe-Trägerbereich 31 weitere optische Bauelemente aufweisen würde, würden diese ebenfalls mit der transparenten Kunststoffmasse 41 vergossen. Im Anschluss werden die restlichen Bauteile und Bereiche mit der nichttransparenten Kunststoffmasse 42 gepackaged. Es spielt dabei keine Rolle, ob zunächst ein Verguss mit der nichttransparenten oder mit der transparenten Kunststoffmasse erfolgt.

Das Modul weist dabei einen sogenannten Bondumsteiger 7 auf. Es handelt sich hierbei um einen leitenden Bereich, von dem zum einen ein Bonddraht zur optischen Komponente 1 und zum anderen ein Bonddraht zum elektronischen Baustein 2 ausgeht. Der Bondumsteiger 7 läuft dabei durch die Grenzfläche zwischen dem transparenten Kunststoff 41 und dem nichttransparenten Kunststoff 42. Der Bondumsteiger 7 ermöglicht trotz der Verwendung zweier Kunststoffe eine elektrischen Kontaktierung zwischen der Komponente 1 und dem elektronischen Baustein 2. Zusätzlich wird eine Abstützfläche für ein Spritzwerkzeug bereitgestellt.

Der Bondumsteiger 7 kann mit unterschiedlichen Materialien realisiert werden. Beispielsweise wird er realisiert durch einen Bereich des Leadframes, durch eine beschichtete Keramik, durch eine strukturierte Kunststoff-Trägerschicht (etwa aus Polyimid) oder durch eine Leiterplatte.

Die Figur 4 zeigt ein viertes Ausführungsbeispiel eines optischen Moduls. Das Herstellungsverfahren entspricht im Wesentlichen dem der Figur 3. Anders als bei der Ausgestaltung der Figur 3 ist die optische Komponente 1 (beispielsweise ein LED-Chip oder ein Fotodiodenchip) auf der einen Seite eines Trägers 3 und sind elektrische Komponenten wie z. B. ein elektronischer Baustein 2 sowie Widerstände und Kondensatoren auf der anderen Seite des Trägers 3 angeordnet. Der Träger 3 ist dabei bevorzugt wiederum als Leadframe ausgebildet. Die optische Komponente 1 befindet sich auf einem Substrat 8 mit Durchkontaktierungen 81, um die elektrischen Kontakte zum Leadframe 3 auf die Oberseite des Substrates 8 zu führen. Bei dem zusätzlichen Substrat 8 handelt es sich beispielsweise um eine Leiterplatte oder um eine strukturierte Polyimid-Schicht (handelsübliche Bezeichnung: Kapton®).

Zur Herstellung dieser Ausführungsform wird in einer Variante die Seite mit der optischen Komponente ausschließlich mit einem transparenten Kunststoffmaterial umspritzt. Die gegenüberliegende Seite mit den elektrischen Komponenten wird dagegen mit einem nichttransparenten Kunststoffmaterial umspritzt.

Um das Volumen der transparenten Kunststoffmasse so gering wie möglich zu halten, ist allerdings bevorzugt auch bei dieser Ausgestaltung vorgesehen, auf der Seite mit der optischen Komponente 1 lediglich diese mit einer transparenten Kunststoffmasse 41 zu umspritzen, während die übrigen Bereiche (insbesondere das Leadframe 3 sowie das weitere Substrat 9) mit einer nichttransparenten Kunststoffmasse 42, 42' umspritzt sind. Diese Situation ist in der Fig. 4 dargestellt.

Es wird darauf hingewiesen, dass die Komponente 1 auch eine elekronische Komponente sein kann. Es kann es sich bei der Komponente 1 beispielsweise um einen Sensor-Chip handeln, insbesondere um einen Drucksensor oder einen Temperatursensor, wie sie in der Automobilindustrie Anwendung findet.

Des Weiteren wird darauf hingewiesen, dass das Modul mehrere optische oder elektronische Komponenten der beschriebenen Art aufweisen kann, wobei dann für jede der Komponenten lokal ein transparentes Vergussmaterial bereitgestellt wird.

Schließlich wird auch darauf hingewiesen, dass die Herstellung des optischen oder elektronischen Moduls bevorzugt im Nutzen auf einem Multinest-Werkzeug erfolgt, wobei nach Beendigung des Herstellungsverfahrens die einzelnen optischen oder elektronischen Module vereinzelt werden.

## Patentansprüche

1. Optisches oder elektronisches Modul mit
- mindestens einer optischen oder elektronischen Komponente (1), die einen Wirkbereich (11) aufweist, über den sie in Wirkverbindung mit der Umgebung steht,
- einem Kunststoffgehäuse (4), in dem die Komponente (1) angeordnet ist, wobei
- das Kunststoffgehäuse (1) einen ersten Bereich (41, 61) aufweist, der aus einer transparenten Kunststoffmasse besteht, und einen zweiten Bereich (42), der aus einer nichttransparenten Kunststoffmasse besteht, und wobei
- der erste Bereich (41, 61) sich angrenzend an den Wirkbereich (11) der Komponente (1) erstreckt.

2. Modul nach Anspruch 1, **dadurch gekennzeichnet, dass** angrenzend an den ersten Bereich (41) eine Öffnung (43) im zweiten Bereich (42) ausgebildet ist, wobei der Wirkbereich (11) der Komponente (1) über den ersten Bereich (41) und die Öffnung (43) mit der Umgebung in Wirkverbindung steht.

3. Modul nach Anspruch 1 oder 2, **dadurch gekennzeichnet, dass** der erste Bereich (41) an der dem Wirkbereich der Komponente abgewandten Seite eine lichtformende oder lichtführende Struktur (41a) ausbildet.

4. Modul nach Anspruch 1, **dadurch gekennzeichnet, dass** der zweite Bereich (42) sich seitlich an den ersten Bereich (41) anschließt und dabei weitere Bauteile (2, 3) des Moduls mit der nichttransparenten Kunststoffmasse umhüllt.

5. Modul nach Anspruch 4, **dadurch gekennzeichnet, dass** die Komponente (1) und der daran angrenzende erste Bereich (61) des Kunststoffgehäuses als vorgefertigtes Package (6) ausgebildet und als solches auf einen Träger (3) des Moduls aufgesetzt sind, wobei der nachfolgend angebrachte zweite Bereich (42) des Kunststoffgehäuses das vorgefertigte Package (6) teilweise umschließt, jedoch den ersten Bereich (61) nicht abdeckt.

6. Modul nach Anspruch 4, **dadurch gekennzeichnet, dass** sich an der Grenze zwischen dem ersten Bereich (41) des Kunststoffgehäuses und dem zweiten Bereich (42) des Kunststoffgehäuses ein Bondumsteiger (7) befindet, von dem sich ein erster Bonddraht in den ersten Bereich und ein zweiter Bonddraht in den zweiten Bereich erstreckt.

7. Modul nach Anspruch 1, **dadurch gekennzeichnet, dass** zusätzlich ein Träger (3) vorgesehen ist und die optische oder elektronische Komponente (1) auf der einen, ersten Seite des Trägers (3) und mindestens ein weiteres Bauteil (2) des Moduls auf der anderen, zweiten Seite des Trägers (3) angeordnet sind, wobei der zweite Bereich (42) des Kunststoffgehäuses die auf der zweite Seite des Trägers (3) angeordneten Bauteile umhüllt.

8. Modul nach Anspruch 7, **dadurch gekennzeichnet, dass** der zweite Bereich (42) des Kunststoffgehäuses (4) sich teilweise auch auf die erste Seite des Trägers (3) erstreckt, dabei aber den ersten Bereich (41) mit der transparenten Kunststoffmasse nicht abdeckt.

9. Modul nach Anspruch 7 oder 8, **dadurch gekennzeichnet, dass** die optische oder elektronische Komponente (1) mittels einer Leiterplatte (8) mit Durchkontaktierungen (81) auf dem Träger angeordnet ist.

10. Modul nach mindestens einem der vorangehenden Anspruche, **dadurch gekennzeichnet, dass** die optische Komponente (1) ein opto-elektronisches Sendebauelement oder ein opto-elektronisches Empfangsbauelement ist.

11. Modul nach mindestens einem der vorangehenden Ansprüche, **dadurch gekennzeichnet, dass** die elektronische Komponente ein Sensor, insbesondere ein Drucksensor oder ein Temperatursensor ist.

12. Verfahren zum Herstellen eines mit einem Kunststoffgehäuse versehenen optischen oder elektronischen Moduls, mit folgenden Schritten:
- Bereitstellen mindestens einer optischen oder elektronischen Komponente (1), wobei die Komponente einen Wirkbereich (11) aufweist, über den sie im fertigen Modul in Wirkverbindung mit der Umgebung steht,
- Umhüllen der Komponente (1) zumindest angrenzend an den Wirkbereich mit einer ersten, transparenten Kunststoffmasse (41),
- Umhüllen der Komponente (1), der ersten transparenten Kunststoffmasse (42) und, soweit vorhanden, weiterer Bauteile (2) des Moduls mit einer zweiten, nichttransparenten Kunststoffmasse (42),
- partielles Entfernen der zweiten Kunststoffmasse (42) von außen derart, dass die erste Kunststoffmasse (41) freigelegt wird und die Komponente (1) über die erste Kunststoffmasse (41) in Wirkverbindung mit der Umgebung treten kann.

13. Verfahren nach Anspruch 12, **dadurch gekennzeichnet, dass** nach dem partiellen Entfernen der zweiten Kunststoffmasse in der ersten Kunststoffmasse an der dem Wirkbereich der Komponente (1) abgewandten Seite eine lichtformende oder lichtführende Struktur (41a) ausbildet wird.

14. Verfahren nach Anspruch 12 oder 13, **dadurch gekennzeichnet, dass** die optische oder elektronische Komponente (1) vor dem Umhüllen auf einem Träger (3) angeordnet wird.

15. Verfahren zum Herstellen eines mit einem Kunststoffgehäuse versehenen optischen oder elektronischen Moduls, mit folgenden Schritten:
- Bereitstellen mindestens eines vorgefertigen Package (6) mit einer optischen oder elektronischen Komponente (1) und einer Umhüllung der Komponente bestehend aus einer ersten, transparenten Kunststoffmasse (61), wobei die Komponente (1) einen Wirkbereich (11) aufweist, über den sie im fertigen Modul in Wirkverbindung mit der Umgebung steht, und die Umhüllung zumindest an den Wirkbereich angrenzt,
- Anordnen des vorgefertigen Package (6) auf einem Träger (3),
- Umhüllen des Package (6), des Trägers (1) und, soweit vorhanden, weiterer Bauteile (2) des Moduls mit einer zweiten, nichttransparenten Kunststoffmasse (42), wobei
- die zweite Kunststoffmasse (42) derart angebracht wird, dass sie das vorgefertigte Package (6) teilweise umschließt, die erste Kunststoffmasse (61) des vorgefertigten Package (6) aber nicht abdeckt.

16. Verfahren zum Herstellen eines mit einem Kunststoffgehäuse versehenen optischen oder elektronischen Moduls, mit folgenden Schritten:
- Bereitstellen mindestens eines vorgefertigen Package (6) mit einer optischen oder elektronischen Komponente (1) und einer Umhüllung der Komponente bestehend aus einer ersten, transparenten Kunststoffmasse (61), wobei die Komponente (1) einen Wirkbereich (11) aufweist, über den sie im fertigen Modul in Wirkverbindung mit der Umgebung steht, und die Umhüllung zumindest an den Wirkbereich angrenzt,
- Anordnen des vorgefertigen Package (6) auf einem Träger (3),
- vollständiges Umhüllen des Package (6), des Trägers (1) und, soweit vorhanden, weiterer Bauteile (2) des Moduls mit einer zweiten, nichttransparenten Kunststoffmasse (42),
- partielles Entfernen der zweiten Kunststoffmasse (42) von außen derart, dass die erste Kunststoffmasse (61) des Package (6) freigelegt wird und die Komponente (1) über die erste Kunststoffmasse (61) in Wirkverbindung mit der Umgebung treten kann.

17. Verfahren nach Anspruch 12 oder 16, **dadurch gekennzeichnet, dass** das partielle Entfernen der zweiten Kunststoffmasse (42) durch einen Fräsprozess oder ein Laser-Abtragverfahren erfolgt, wobei die zweite Kunststoffmasse bis auf die erste transparente Kunststoffmasse (61) abgetragen wird.

18. Verfahren zum Herstellen eines mit einem Kunststoffgehäuse versehenen optischen oder elektronischen Moduls, mit folgenden Schritten:
- Bereitstellen mindestens einer optischen oder elektronischen Komponente (1), wobei die Komponente einen Wirkbereich (11) aufweist, über den sie im fertigen Modul in Wirkverbindung mit der Umgebung steht,
- Umhüllen der Komponente (1) zumindest angrenzend an den Wirkbereich (11) mit einer ersten, transparenten Kunststoffmasse (41),
- Umhüllen mindestens eines weiteren Bauteils (2, 3) des Moduls mit einer zweiten, nichttransparenten Kunststoffmasse (42),
- wobei die erste und die zweite Kunststoffmasse (41, 42) in unterschiedlichen Bereichen des Moduls ausgebildet werden.

19. Verfahren nach Anspruch 18, wobei die erste und die zweite Kunststoffmasse (41, 42) nebeneinander im Modul ausgebildet werden.

20. Verfahren nach Anspruch 18, wobei zusätzlich ein Träger (3) vorgesehen ist, auf dessen einen, ersten Seite sich die optische oder elektronische Komponente (1) befindet, und auf deren anderer, zweiten Seite sich das mindestens eine weitere Bauteil (2) des Moduls befindet, wobei die erste und die zweite Kunststoffmasse auf unterschiedlichen Seiten des Moduls angebracht werden.

21. Verfahren nach Anspruch 20, wobei die zweite Kunststoffmasse (42) derart bereitgestellt wird, dass sie sich teilweise auch auf die erste Seite des Trägers (3) erstreckt.

22. Verfahren nach mindestens einem der Ansprüche 18 bis 21, wobei die erste Kunststoffmasse (41) und die zweite Kunststoffmasse (42) in einen Zwei-Komponenten-Spritzverfahren bereitgestellt werden.
